(19) Europäisches Patentamt
European Patent Office
Office européen des brevets

(11) **EP 1 329 772 B1**

(12) **EUROPEAN PATENT SPECIFICATION**

(45) Date of publication and mention
of the grant of the patent:
**25.03.2009 Bulletin 2009/13**

(51) Int Cl.:
***G03F 7/20*** (2006.01)

(21) Application number: **02258992.3**

(22) Date of filing: **27.12.2002**

(54) **Lithographic projection apparatus and device manufacturing method**

Lithographischer Projektionsapparat und Verfahren zur Herstellung eines Artikels

Appareil de projection lithographique et méthode pour la fabrication d'un dispositif

(84) Designated Contracting States:
**DE FR GB IT NL**

(30) Priority: **28.12.2001 EP 01310947**

(43) Date of publication of application:
**23.07.2003 Bulletin 2003/30**

(73) Proprietor: **ASML Netherlands B.V.**
**5504 DR Veldhoven (NL)**

(72) Inventors:
• **Bakker, Leon**
**5708 ZT Helmond (NL)**
• **Jonkers, Jeroen**
**52062 Aachen (DE)**
• **Visser, Hugo Matthieu**
**3512 VK Utrecht (NL)**

(74) Representative: **Van den Hooven, Jan et al**
**ASML Netherlands B.V.**
**Corporate Intellectual Property**
**P.O. Box 324**
**5500 AH Veldhoven (NL)**

(56) References cited:
**EP-A- 1 150 169**           **WO-A-01/49086**
**WO-A-01/95362**           **WO-A-02/31932**

**Description**

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, incorporated herein by reference.

In a lithographic apparatus the size of features that can be imaged onto the substrate is limited by the wavelength of the projection radiation. To produce integrated circuits with a higher density of devices, and hence higher operating speeds, it is desirable to be able to image smaller features. Whilst most current lithographic projection apparatus employ ultraviolet light generated by mercury lamps or excimer lasers, it has been proposed to use shorter wavelength radiation of around 13nm. Such radiation is termed extreme ultraviolet (EUV) or soft x-ray and possible sources include, for instance, laser-produced plasma sources, discharge plasma sources, or synchrotron radiation from electron storage rings.

In a typical discharge plasma source, a plasma is formed by an electrical discharge. The plasma may then be caused to compress so that it becomes highly ionized and reaches a very high temperature, causing the emission of EUV radiation. The material used to produce the EUV radiation is typically xenon or lithium vapor, although other gases such as krypton or tin or water vapor may also be used. However, these gases may have a relatively high absorption of radiation within the EUV range or be damaging to optics further downstream of the projection beam and their presence must therefore be minimized in the remainder of the lithographic apparatus. A discharge plasma source is disclosed, for instance, in US 5,023,897 and US 5,504,795, incorporated herein by reference.

In a laser-produced plasma source a jet of, for instance, (clustered) xenon may be ejected from a nozzle. At some distance from the nozzle, the jet is irradiated with a laser pulse of a suitable wavelength for creating a plasma that subsequently will irradiate EUV radiation. Other materials, such as water droplets, ice particles, lithium or tin vapor, etc. may also be ejected from a nozzle and be used for EUV generation. In an alternative laser-produced plasma source an extended solid (or liquid) material is irradiated to create a plasma for EUV radiation. Laser-produced plasma sources are, for instance, disclosed in US 5,459,771, US 4,872,189 and US 5,577,092, incorporated herein by reference.

A common feature of the above sources is that their operation induces a background pressure of some source gas or gasses (also including vapors) in or near the source region. Source gasses comprise those gasses or vapors of which a plasma is to be created for EUV generation, but also gasses or vapors produced during source operation by, for instance, laser irradiation of a solid or liquid material. The source gasses should be confined to the source region since they may be a cause of substantial absorption of EUV radiation or be a cause of contamination and damage in the remainder of the lithographic apparatus.

Systems employing projection radiation having a higher wavelength than EUV radiation typically separate gases present in the source from the remainder of the system using transparent windows. These windows block the movement of the gases from the source but allow the projection beam to pass through. However, no material has yet been proposed which is sufficiently transparent to EUV radiation to allow the use of transparent windows with EUV projection beams. An alternative system, which has been used to contain gases within the source area of an EUV apparatus, is an argon counterflow. An example of this type of system is described in US 5,023,897. In apparatus of this type, argon is pumped into the source in a direction which is counter to the direction of the radiation beam. This system attempts to drive the gases in the source away from the evacuated parts of the lithographic apparatus. However, this system may generate turbulence within the source, which causes problems to the operation of the apparatus. Further, the contamination of the gas present in the source by argon can be problematic. Xenon, a typical gas for use in a plasma source, is expensive and is therefore preferably recycled. However, it is difficult to regenerate xenon from a mixture of gases. Xenon's contamination with argon in such a counterflow device therefore significantly adds to the cost of the recycling step.

WO 0231932 A, which is considered as comprised in the prior art under Article 54(3) EPC, discloses a gas discharge laser system. The laser system comprises two sealed chambers for isolating a laser beam line between laser modules.

WO 01 49086 A discloses a method for generating EUV radiation, comprising the steps of generating a flow of a medium; transporting this medium through a source, connected to a vacuum pump, and irradiating part of the medium with an intensive, pulsed laser beam focused on said part of the medium, thus creating a plasma which emits EUV radiation. In order to maintain a vacuum in the source space and to prevent elements of the medium, like vapor or elementary particles, from leaving the source space through apertures provided in the wall of the space for passing the laser beam and EUV radiation, the flow of medium is embedded in a flow of rare gas.

WO 01 95362 A discloses a high energy photon source having a pair of plasma pinch electrodes located in a vacuum chamber. The vacuum chamber contains a working gas which includes a noble buffer gas and an active gas. Gas flows in the vacuum chamber are controlled to ensure desired concentration of active gas in the discharge region and to minimize active gas concentration in the beam path downstream of the pinch region. In a preferred embodiment, active gas is injected downstream of the pinch region through a nozzle and exhausted axially through an exhaust port through the center of the anode. In another preferred embodiment a laser beam generates metal vapor at a location close to but downstream of the pinch region and the vapor is exhausted axially through the anode.

EP-A-1 150 169 discloses a gas jet nozzle for an EUV source. The housing of the nozel has a gas-expelling primary channel located centrally within the housing and a gas-expelling secondary channel proximate the primary channel. A secondary gas stream expelled from the secondary channel restricts the lateral expansion of a primary gas stream expelled from the primary channel, optimizing gas jet properties and reducing heating and erosion of the nozzle.

It is an object of the present invention to provide a lithographic apparatus which is suitable for use with a discharge or laser-produced plasma source of extreme ultraviolet radiation and which restricts the gases in or near the source from entering further parts of the apparatus.

This and other objects according to the invention are achieved in a lithographic apparatus as specified in claim 1.

The presence of the buffer gas in the second space impedes the movement of the source gas into the second space. Furthermore, any source gas entering the second space may be effectively pumped away together with buffer gas that is typically continuously refreshed. Thus, the apparatus of the present invention enables the gases from a plasma source to be substantially contained within a particular space and to be restricted from entering the remainder of the apparatus. The transmission of the projection beam through the apparatus may thus be increased and any contamination or damage to optics further downstream may be prevented. The invention does not require the use of a transparent window or counterflow system and thus avoids the problems associated with the prior art methods described above. In particular, movement of buffer gas into the space containing the source is prevented. Therefore, the gases used in the source remain substantially pure and can be regenerated for re-use relatively cheaply.

According to a further aspect of the invention there is provided a device manufacturing method according to claim 7.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and extreme ultra-violet (ELM) radiation (*e.g.* having a wavelength in the range 5-20 nm), as well as particle beams, such as ion beams or electron beams.

Embodiments of the invention will now be described, by way of example only, with reference to the accompanying schematic drawings in which:

    Figure 1 depicts a lithographic projection apparatus according to an embodiment of the invention;
    Figure 2 schematically depicts a preferred embodiment of the invention; and
    Figure 3 depicts an extreme ultra-violet radiation source which is suitable for use with the present invention.

In the Figures, corresponding reference symbols indicate corresponding parts.

Embodiment 1

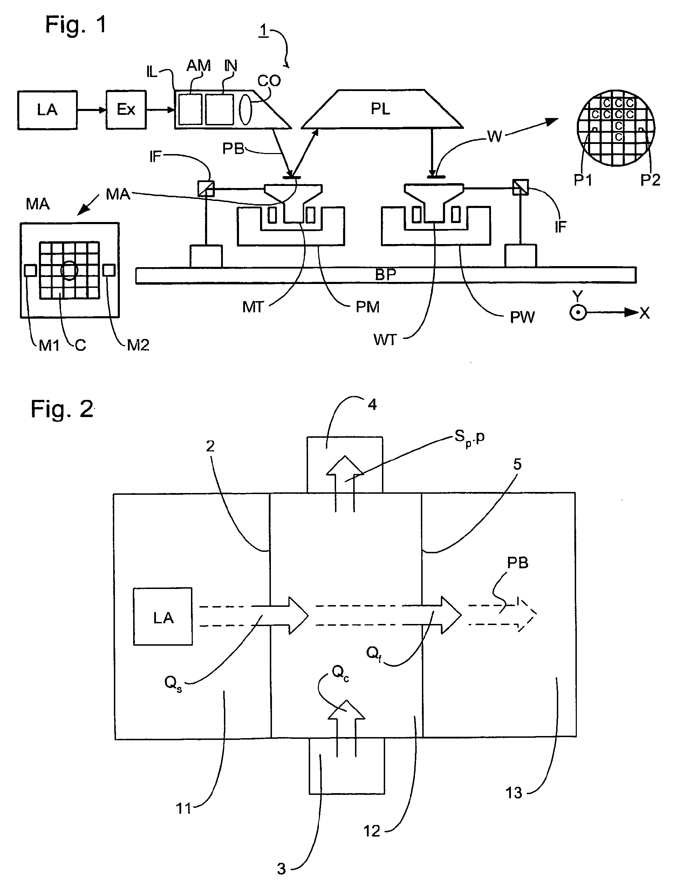

Figure 1 schematically depicts a lithographic projection apparatus according to a particular embodiment of the invention. The apparatus comprises:

· a radiation system Ex, IL, for supplying a projection beam PB of radiation (*e.g.* EUV radiation), which in this particular case also comprises a radiation source LA;
· a first object table (mask table) MT provided with a mask holder for holding a mask MA (*e.g.* a reticle), and connected to first positioning means PM for accurately positioning the mask with respect to item PL;
· a second object table (substrate table) WT provided with a substrate holder for holding a substrate W (*e.g.* a resist-coated silicon wafer), and connected to second positioning means PM for accurately positioning the substrate with respect to item PL;
· a projection system ("lens") PL for imaging an irradiated portion of the mask MA onto a target portion C (*e.g.* comprising one or more dies) of the substrate W.

As here depicted, the apparatus is of a reflective type (*i.e.* has a reflective mask). However, in general, it may also be of a transmissive type, for example (with a transmissive mask). Alternatively, the apparatus may employ another kind of patterning means, such as a programmable mirror array of a type as referred to above.

The source LA (*e.g.* a discharge plasma source or a laser-produced plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed $V = Mv$, in which M is the magnification of the lens PL (typically, $M = 1/4$ or $1/5$). In this manner, a relatively large target portion C can be exposed, without having to compromise on resolution.

An embodiment of the present invention is depicted schematically in Figure 2. In this embodiment, the source LA, which is a plasma source for producing extreme ultraviolet radiation (e.g. having a wavelength in the range of from 5 to 20 nm, especially from 9 to 16nm) is contained within a first space, or source zone, 11. The source LA is preferably a discharge or laser-produced plasma source for producing EUV radiation. Any such plasma source may be used in combination with the present invention, for example the discharge plasma sources described in European patent applications EP 01305671.8 [P-0191] and EP 00311177.0 [P-0162] and those disclosed in the US references referred to earlier.

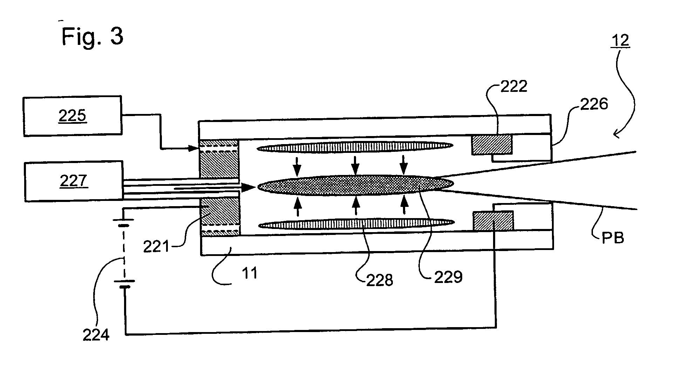

The source zone is separated from a second space, or buffer zone, 12, for example, by a wall 2, which contains an orifice through which EUV radiation can pass and gases can escape. The projection beam PB passes from source LA through the orifice and thence through the buffer zone. It is particularly preferred that the orifice in the wall separating the source zone and the buffer zone is the source orifice, or is immediately adjacent to the source orifice. An example of a source for use with the present invention is depicted in Figure 3 and is described further below with reference to Embodiment 2.

The source zone contains a source gas, selected for its efficient generation of EUV radiation when brought into a plasma state by laser irradiation or an electrical discharge. Examples of such gases are xenon, krypton, lithium vapor, tin vapor and water vapor. The source gas is desirably prevented or restricted from entering the part of the apparatus through which the projection beam passes, so that transmission of the projection beam through the apparatus can be maximized, or contamination and damage of optics further downstream of the projection beam can be prevented.

The buffer zone contains a buffer gas, which is a gaseous system preferably having a low absorption of radiation at the wavelength of the projection beam, i.e. a low EUV absorption. Examples of such gases are argon, helium, nitrogen and hydrogen. The buffer gas may contain one or a mixture of these gases.

The pressure of the buffer gas in the buffer zone is chosen to be less than or approximately equal to the pressure of the source gas in the source zone. This ensures that substantially no flow of buffer gas into the source zone occurs and that the source gas remains substantially pure. In contrast, a moderate flow or some diffusion of source gas from the source zone to the buffer zone is tolerated so that the buffer zone may contain a mixture of buffer gas and source gas. Where the source zone contains a discharge plasma source, this feature is particularly important since the presence of gases such as argon, nitrogen, helium and hydrogen in the source can be problematic. By adjustment of the pressure and temperature in the buffer zone, the gas flow through the source orifice can be controlled. Typically, the pressure of the buffer gas is of the same order of magnitude as the source gas, suitable pressures for both gaseous systems being in the region of 0.1mbar, for example from 0.05 to 0.15mbar.

The apparatus may be equipped with a supply 3 for supplying buffer gas to the buffer zone and a pump 4 for removing gas from the buffer zone. Pump 4 preferably removes gas in a direction which is substantially perpendicular to the direction of the projection beam. Gas present in the buffer zone can in this way be refreshed. This may be achieved by selective removal of the source gas from the mixture of source gas and buffer gas. For example, a cryopump using a cold-spot at the liquid nitrogen temperature may be used to selectively remove xenon from a mixture of xenon and helium or argon. This is possible since xenon is solid at the boiling point of liquid nitrogen, whilst both helium and argon are gaseous. Generally, all gasses in zone 12 will be pumped away and fresh buffer gas supplied by supply 3. However, pump 4 may also be dispensed with.

Typically, the buffer zone 12 will be adjacent to a third substantially evacuated zone 13. Typically, the zone 13 comprises the illumination system or other parts of the apparatus through which the projection beam passes and is evacuated to ensure maximum transmission of the projection beam. A differential pumping system is required in order to retain the vacuum in zone 13 whilst retaining a low pressure of buffer gas in the buffer zone.

The movement of gas through the zones may be described as follows and is depicted in Figure 2: the gas is pumped from the buffer zone into zone 13 through a restricted opening in wall 5 resulting in gas flow $Q_f$. Pump 4 removes gas from the buffer zone at a rate $S_p$, resulting in a gas outflow $S_p p$, wherein p is the pressure in the buffer zone. Fresh buffer gas is supplied to the buffer zone by supply 3 causing a gas in-flow $Q_e$. A further movement of gas occurs due to the source gas flowing out of the source zone or, when the source and buffer zones are at approximately equal pressures, diffusing out of the source zone. This is defined as gas flow $Q_s$.

The gas flows $Q_f$ and $S_p p$ both contain a fraction θ of source gas. Flow $Q_s$ is assumed to comprise only source gas. Assuming a constant pressure in the buffer zone, the particle balance for the source gas can be defined as follows:

$$Q_s = \theta . S_p p + \theta . Q_f \qquad (1)$$

The expression for the flow through the restricted opening in wall 5 is:

$$Q_{f,Source} = \theta . Q_f = \frac{Q_s}{1 + \dfrac{S_p p}{Q_f}} \qquad (2)$$

It is clear from this expression that the amount of source gas in the gas flow $Q_f$ decreases with increasing refreshment rate of the buffer gas. Thus, the presence of the buffer gas impedes the source gas from exiting the source and substantially reduces the amount of source gas which enters the buffer chamber and therefore the remainder of the system.

In one embodiment of the invention, additional source gas is added close to the source orifice in order to restrict the flow of buffer gas into the source. For example, the source described by Bergmann *et al* (Appl. Optics 38, 5413 (1999)) may be used to achieve this. This source has a conical orifice, which may be continuously filled and refreshed with source gas. The diffusional flux of buffer gas into the source may thus be reduced to a negligible level. Preferably, the additional flow of source gas caused by this embodiment should be of the same order of magnitude as the diffusional mixing of buffer and source gases at the source orifice.

Embodiment 2

A second embodiment of the invention, which may be the same as the first embodiment except as described below, is depicted in Figure 3. Figure 3 depicts a Z-pinch plasma discharge source comprising a cylindrical source zone 11. EUV radiation is produced within the source zone and emitted via a source orifice defined by flange 226, into buffer zone 12 which is the space outside the source zone 11.

In this embodiment, a first source gas is injected into the source zone from source 225 and pre-ionized. This gas is chosen for its ability to generate a high-temperature plasma. A voltage is applied between annular anode 222 and annular cathode 221 from voltage source 224, thus generating a pinch volume 229 at high temperature and pressure. A further source gas, which is chosen for its efficiency in emitting EUV radiation, may be injected into the pinch volume from source 227. The source gases within the pinch volume are compressed and heated to emit an EUV projection beam PB which exits the source zone via the orifice into buffer zone 12.

Buffer gas is supplied to buffer zone 12 in order to reduce the effect of source gas exiting source zone 11 through the orifice, as described above in Embodiment 1.

Example

The following very simplified example calculates the fraction of source gas which enters the vacuum system of a lithography apparatus using the buffer system of the present invention.

The apparatus used is that schematically depicted in Figure 2. The zone 11 is a discharge plasma source, for example that depicted in Figure 3, containing xenon as the source gas. The source comprises a source orifice defined by a flange, for example a flange 226 as depicted in Figure 3 or a conical 20mm thick flange. The buffer zone 12 contains argon at a pressure of 0.1mbar and a temperature of 400K. The pressure in the source zone 11 is slightly higher than this. The zone 13 is evacuated. The mean free path of xenon atoms in argon is in the order of 1mm for an argon temperature of 400K. This length, and the size of the source orifice, is small enough to ensure that the mixing of xenon and argon at the source orifice is diffusional.

The gas flow due to diffusional flux can be written as

$$Q_s = kT \frac{\pi}{4} d^2 . D_{12} . \frac{\partial n_{Xe}}{\partial x} \approx kT \frac{\pi}{4} d^2 . D_{12} . \frac{\Delta n_{Xe}}{\Delta x} \qquad (3)$$

where k is Boltzmann's constant, T is the gas (xenon) temperature, $D_{12}$ is the diffusion coefficient of the xenon-argon mixture, d is the diameter of the source orifice and $n_{Xe}$ is the xenon density. The derivative can be approximated by the difference in the xenon density $\Delta n_{Xe}$ over the length $\Delta x$. The diffusion coefficient $D_{12}$ for a mixture of xenon and argon at a pressure of 0.1 mbar and a temperature of 400K is $2 \times 10^3$ cm$^2$/s. For the density gradient, we assume the xenon density to decrease to approximately zero over the length equal to the thickness of the source orifice flange. The resulting diffusional 'flow' $Q_s$ through the source orifice is 0.02 mbar.l/s. This flow is almost an order of magnitude lower than the flow through the orifice when the source is directly connected to the vacuum system (which would be 0.23 mbar.l/s). $Q_f$ is assumed to be equal to 10 mbar.l/s and $S_p$ is taken as 100 l/s. Thus, using expression (2) above, the xenon fraction of the flow $Q_f$ is 0.01 mbar.l/s. The xenon pressure in the buffer zone is $1 \times 10^{-4}$ mbar. For a 7cm optical path, the EUV transmission will increase from 0.73 to 0.90.

Whilst specific embodiments of the invention have been described above, it will be appreciated that the invention may be practiced otherwise than as described. The description is not intended to limit the invention.

**Claims**

**1.** A lithographic projection apparatus (1) comprising:

- a radiation system for providing a projection beam of radiation (PB);
- a support structure (MT) for supporting patterning means (MA), the patterning means (MA) serving to pattern the projection beam (PB) according to a desired pattern;
- a substrate table (WT) for holding a substrate (W);
- a projection system (PL) for projecting the patterned beam (PB) onto a target portion of the substrate (W);
- a plasma source (LA) for producing a beam of extreme ultraviolet radiation, which plasma source (LA) is a part of said radiation system; and
- a first space (11) containing (i) said plasma source (LA) and (ii) source gas from said plasma source (LA) ; **characterized by** further comprising:

   - a second space (12) separated from said first space (11) by a wall (2) containing a beam aperture, said second space (12) containing a buffer gas which is different from said source gas; wherein the pressure of said buffer gas in said second space (12) is less than or approximately equal to the pressure of said source gas in said first space (11) and wherein said projection beam (PB) passes through said beam aperture and said first and second spaces.

2. An apparatus (1) according to claim 1, wherein said source gas comprises xenon, lithium vapor, tin vapor, krypton or water vapor.

3. An apparatus (1) according to any one of the preceding claims, wherein said buffer gas is one or a mixture of gases selected from argon, nitrgoen, helium and hydrogen.

4. An apparatus (1) according to any one of the preceding claims, which further comprises means (3) to supply said buffer gas to said second space (12).

5. An apparatus (1) according to any one of the preceding claims, which further comprises means (4) to remove gas from said second space (12).

6. An apparatus (1) according to any one of the preceding claims, wherein the support structure (MT) comprises a mask table (MT) for holding a mask (MA).

7. A device manufacturing method comprising the steps of:

   - providing a substrate (W) that is at least partially covered by a layer of radiation-sensitive material;
   - providing a projection beam (PB) of radiation using a radiation system;
   - using patterning means (MA) to endow the projection beam (PB) with a pattern in its cross-section;
   - projecting the patterned beam of radiation onto a target portion of the layer of radiation-sensitive material;
   - using a plasma source (LA) as defined in claim 1 to provide said projection beam (PB); and
   - providing a first space (11) as defined in claim 1; **characterized by** further comprising:

   - providing a buffer gas which is different from said source gas to said second space (12), such that the pressure of said buffer gas in said second space (12) is less than or approximately equal to the pressure of said source gas in said first space (11); wherein said second space (12) is separated from said first space (11) by a wall containing a beam aperture; and wherein said projection beam passes through said beam aperture and said first and second spaces.

**Patentansprüche**

1. Lithographische Projektionsvorrichtung (1), mit:

   • einem Strahlungssystem zum Bereitstellen eines Projektionsstrahls aus Strahlung (PB);
   • einer Haltekonstruktion (MT) zum Halten von Musteraufbringungseinrichtungen (MA), wobei die Musteraufbringungseinrichtungen (MA) dazu dienen, den Projektionsstrahl (PB) gemäß einem gewünschten Muster mit einem Muster zu versehen;
   • einem Substrattisch (WT) zum Halten eines Substrats (W);
   • einem Projektionssystem (PL) zum Projizieren des gemusterten Strahls (PB) auf einen Zielbereich des Substrats (W);

• einer Plasmaquelle (LA) zum Erzeugen eines Strahls aus extrem ultravioletter Strahlung, wobei die Plasmaquelle (LA) ein Teil des Strahlungssystems ist; und mit

• einem ersten Zwischenraum (11), der (i) die Plasmaquelle (LA) und (II) Quellgas von der Plasmaquelle (LA) enthält; **dadurch gekennzeichnet, dass** ferner enthalten ist:

• ein zweiter Zwischenraum (12), der von dem ersten Zwischenraum (11) durch eine Wand (2) getrennt ist, die eine Strahlöffnung enthält, wobei der zweite Zwischenraum (12) ein Puffergas enthält, das sich von dem Quellgas unterscheidet; wobei der Druck des Puffergases in dem zweiten Zwischenraum (12) niedriger oder annähernd gleich ist wie der Druck des Quellgases in dem ersten Zwischenraum (11) und wobei der Projektionsstrahl (PB) durch die Strahlöffnung und den ersten und den zweiten Zwischenraum verläuft.

2. Vorrichtung (1) nach Anspruch 1, wobei das Quellgas Xenon, Lithlumdampf, Zinndampf, Krypton oder Wasserdampf umfasst.

3. Vorrichtung (1) nach einem der vorhergehenden Ansprüche, wobei das Puffergas eines bzw. eine Mischung der Gase ist, die aus Argon, Stickstoff, Helium und Wasserstoff ausgewählt werden.

4. Vorrichtung (1) nach einem der vorhergehenden Ansprüche, die ferner Einrichtungen (3) zum Zuführen des Puffergases in den zweiten Zwischenraum (12) umfasst.

5. Vorrichtung (1) nach einem der vorhergehenden Ansprüche, die ferner Einrichtungen (4) zum Entfernen von Gas aus dem zweiten Zwischenraum (12) umfasst.

6. Vorrichtung (1) nach einem der vorhergehenden Ansprüche, wobei die Haltekonstruktion (MT) einen Maskentisch (MT) zum Halten einer Maske (MA) umfasst.

7. Verfahren zum Herstellen eines Bauelements, das folgende Schritte umfasst:

• Bereitstellen eines Substrats (W), das zumindest teilweise von einer Schicht aus strahlungssensitivem Material bedeckt ist;

• Bereitstellen eines Projektlonsstrahls (PB) aus Strahlung unter Verwendung eines Strahlungssystems;

• Verwenden von Musteraufbringungseinrichtungen (MA), um den Projektionsstrahl (PB) in seinem Querschnitt mit einem Muster zu versehen;

• Projizieren des gemusterten Strahls aus Strahlung auf einen zielbereich der Schicht aus strahlungssensitivem Material;

• Verwenden einer Plasmaquelle (LA), wie sie in Anspruch 1 definiert ist, um den Projektionsstrahl (PB) bereitzustellen; und

• Bereitstellen eines ersten Zwischenraums (11), wie er in Anspruch 1 definiert ist; **dadurch gekennzeichnet, dass** ferner enthalten ist:

• Bereitstellen eines Puffergases, das sich vom Quellgas unterscheidet, für den zweiten Zwischenraum (12), so dass der Druck des Puffergases in dem zweiten Zwischenraum (12) niedriger oder annähernd gleich ist wie der Druck des Quellgases in dem ersten Zwischenraum (11); wobei der zweite Zwischenraum (12) von dem ersten Zwischenraum (11) durch eine Wand getrennt ist, die eine Strahlöffnung enthält; und wobei der Projektionsstrahl durch die Strahlöffnung und den ersten und den zweiten Zwischenraum verlauft.

**Revendications**

1. Appareil de projection lithographique (1) comprenant :

- un système de rayonnement pour délivrer un faisceau de projection (PB) de rayonnement ;

- une structure de support (mit) pour supporter des moyens de mise en forme (MA), les moyens de mise en forme (MA) servant à mettre en forme le faisceau de projection (PB) conformément à un motif voulu ;

- une table de substrat (WT) pour maintenir un substrat (W) ;

- un système de projection (PL) pour projeter le faisceau mis en forme (PB) sur une partie cible du substrat (W) ;

- une source de plasma (LA) pour produire un faisceau de rayonnement ultraviolet extrême, laquelle source de plasma (LA) est une partie dudit système de rayonnement ; et

- un premier espace (11) contenant (i) ladite source de plasma (LA) et (ii) un gaz de source provenant de ladite source de plasma (LA) ; **caractérise en ce qu'**il comprend en outre :

   - un second espace (12) séparé dudit premier espace (11) par une paroi (2) contenant une ouverture de faisceau, ledit second espace (12) contenant un gaz tampon qui est différent dudit gaz de source ; dans lequel la pression dudit gaz tampon dans ledit second espace (12) est inférieure ou approximativement égale à la pression dudit gaz de source dans ledit premier espace (11) et dans lequel ledit faisceau de projection (PB) passe à travers ladite ouverture de faisceau et lesdits premier et second espaces.

2. Appareil (1) selon la revendication 1, dans lequel ledit gaz de source comprend du xénon, de la vapeur de lithium, de la vapeur d'étain, du krypton ou de la vapeur d'eau.

3. Appareil (1) selon l'une quelconque des revendication précédentes, dans lequel ledit gaz tampon est l'un ou un mélange de gaz choisis parmi l'argon, l'azote, l'hélium et l'hydrogène, ou un mélange de ceux-ci.

4. Appareil (1) selon l'une quelconque des revendication précédentes, qui comprend en outre des moyens (3) pour acheminer ledit gaz tampon jusqu'audit second espace (12).

5. Appareil (1) selon l'une quelconque des revendications précédentes, qui comprend en outre des moyens (4) pour retirer du gaz dudit second espace (12).

6. Appareil (1) selon l'une quelconque des revendications précédentes, dans lequel la structure de support (MT) comprend une table de masque (MT) pour maintenir un masque (MA).

7. Procédé de fabrication d'un dispositif Comprenant les étapes de :

   - fournir un substrat (W) qui est au moins partiellement recouvert d'une couche de matériau sensible au rayonnement ;
   - fournir un faisceau de projection (PB) de rayonnement utilisant un système de rayonnement ;
   - utiliser des moyens de mise en forme (MA) pour doter le faisceau de projection (PB) d'un motif dans sa section transversale ;
   - projeter le faisceau de rayonnement mis en forme sur une partie cible de la couche de matériau sensible au rayonnement ;
   - utiliser une source de plasma (LA) telle que définie dans la revendication 1 pour fournir ledit faisceau de projection (PB) ; et
   - fournir un premier espace (11) tel que défini dans la revendication 1 ; **caractérisé en ce qu'**il comprend en outre :

      - la fourniture d'un gaz tampon, qui est différent dudit gaz de source, audit second espace (12), de sorte que la pression dudit gaz tampon dans ledit second espace (12) est inférieure ou approximativement égale la pression dudit gaz de source dans ledit premier espace (11) ; dans lequel ledit second espace (12) est séparé dudit premier espace (11) par une paroi contenant une ouverture de faisceau ; et dans lequel ledit faisceau de projection passe à travers ladite ouverture de faisceau et lesdits premier et second espaces.

## Fig. 1

## Fig. 2

## Fig. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- WO 9838597 A
- WO 9833096 A
- US 5229872 A
- US 6046792 A
- US 5969441 A
- WO 9840791 A
- US 5023897 A
- US 5504795 A

- US 5459771 A
- US 4872189 A
- US 5577092 A
- WO 0231932 A
- WO 0149086 A
- WO 0195362 A
- EP 1150169 A
- EP 01305671 A
- EP 00311177 A